# EUROPEAN PATENT APPLICATION

(11) **EP 2 551 919 A2**
(43) Date of publication of application: **30.01.2013**
(21) Application number: 12005480.4
(22) Date of filing: 27.07.2012
(51) Int. Cl.: H01L 31/042

(54) **Solar cell assembly**

(30) Priority: 29.07.2011 TW 100127030
(71) Applicant: GOD SAW Co. Ltd., Tainan City 711 (TW)
(72) Inventor: Hung, Tai-An, North Dist. Tainan City 704 (TW)
(74) Representative: Mergel, Volker

(57) **Abstract**

A solar cell assembly includes a plurality of solar cells (3) that are electrically connected to one another to form a series connection and that are aligned along an alignment direction (X). Each of the solar cells (3) has opposite first and second end portions (301, 302) that are opposite to each other in the alignment direction (X). The first end portion (301) of a subsequent one of the solar cells (3) in the series connection is stacked on and is electrically connected to the second end portion (302) of a preceding one of the solar cells (3) in the series connection.

## Description

The invention relates to a solar cell assembly, and more particularly to a solar cell assembly including a plurality of solar cells that are partially stacked one above the other.

Referring to Fig. 1, U.S. Patent Application Publication No. 2011/0265849 discloses a solar cell panel that includes a plurality of solar cells 10, interconnectors 11 for electrically connecting in series the solar cells 10 to one another, and front and back protective layers (not shown) sandwiching the solar cells 10 and the interconnectors 11. The solar cell panel thus formed is disadvantageous in that an undesired gap 13 is formed between two adjacent ones of the solar cells 10, which results in a waste of space for the solar cell panel. In addition, the use of the interconnectors 11 in the solar cell panel increases the manufacturing costs.

Therefore, the object of the present invention is to provide a solar cell assembly that can overcome the aforesaid drawbacks associated with the prior art.

According to the present invention, there is provided a solar cell assembly that comprises a plurality of solar cells that are electrically connected to one another to form a series connection and that are aligned along an alignment direction. Each of the solar cells has opposite first and second end portions that are opposite to each other in the alignment direction. The first end portion of a subsequent one of the solar cells in the series connection is stacked on and is electrically connected to the second end portion of a preceding one of the solar cells in the series connection.

In drawings which illustrate embodiments of the invention,

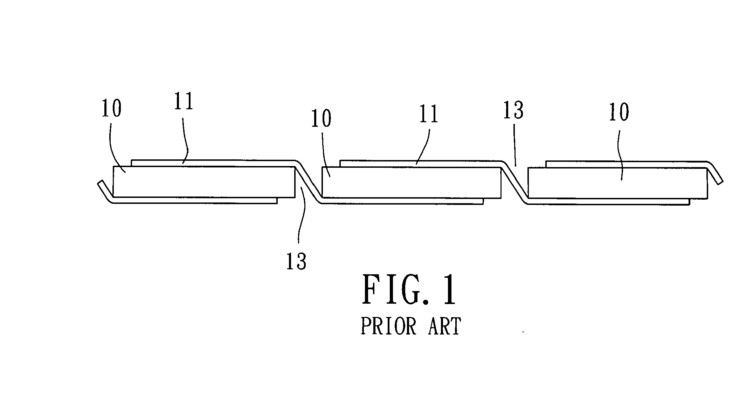

Fig. 1 is a schematic view of a conventional solar cell panel;
Fig. 2 is a perspective view of the first preferred embodiment of a solar cell assembly according to the present invention;
Fig. 3 is a perspective view of a solar cell modified from a solar cell of the first preferred embodiment; and
Fig. 4 is a perspective view of the second preferred embodiment of a solar cell assembly according to the present invention.

Before the present invention is described in greater detail with reference to the accompanying preferred embodiments, it should be noted herein that like elements are denoted by the same reference numerals throughout the disclosure.

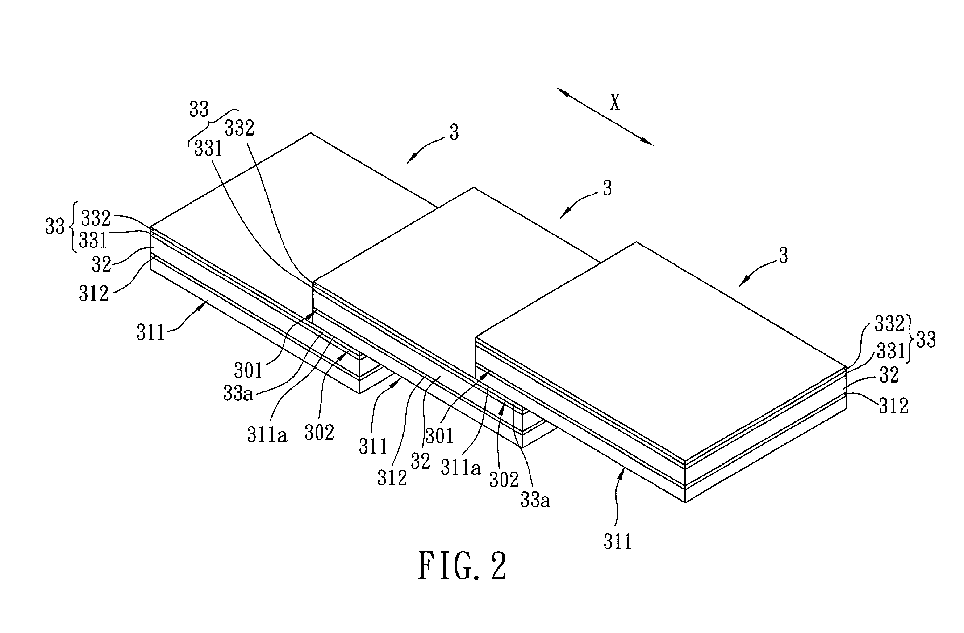

Fig. 2 illustrates the first preferred embodiment of a solar cell assembly according to the present invention. The solar cell assembly includes a plurality of solar cells 3 that are electrically connected to one another to form a series connection and that are aligned along an alignment direction (X). Each of the solar cells 3 has opposite first and second end portions 301, 302 that are opposite to each other in the alignment direction (X). The first end portion 301 of a subsequent one of the solar cells 3 in the series connection is stacked on and is electrically connected to the second end portion 302 of a preceding one of the solar cells 3 in the series connection.

In this embodiment, each of the solar cells 3 includes a metallic substrate 311, a back electrode layer 312 formed on the metallic substrate 311, a top electrode layer structure 33 disposed at one side of the back electrode layer 312 opposite to the metallic substrate 311, and a semiconductor photovoltaic layer 32 disposed between the back electrode layer 312 and the top electrode layer structure 33 and defining a p-n junction (not shown) for conversion of an incident light into an electrical current.

The metallic substrate 311 of each of the solar cells 3 has an end portion 311a corresponding to the first end portion 301 of the respective one of the solar cells 3. The top electrode layer structure 33 of each of the solar cells 3 has an end portion 33a corresponding to the second end portion 302 of the respective one of the solar cells 3. The end portion 311a of the metallic substrate 311 of each subsequent one of the solar cells 3 in the series connection is bonded to the end portion 33a of the top electrode layer structure 33 of the preceding one of the solar cells 3 in the series connection through a conductive paste (not shown).

Preferably, the metallic substrate 311 is flexible, and is made from a metallic material selected from Fe, Cr, Ni, and combinations thereof. In one example, the metallic substrate 311 is made from stainless steel having a composition comprising 60-77wt% of Fe, 15-32wt% of Cr, and 8-25wt% of Ni.

Preferably, the back electrode layer 312 is made from a metal, such as molybdenum (Mo).

Preferably, the semiconductor photovoltaic layer 32 is made from a semiconductor material selected from Si, CdTe, CuInSe, and CuInGaSe.

The top electrode layer structure 33 includes a transparent current diffusion layer 331 formed on the semiconductor photovoltaic layer 32, and a transparent front electrode layer 332 formed on the current diffusion layer 331. Preferably, the transparent current diffusion layer 331 is made from a transparent conductive material selected from indium tin oxide and zinc oxide, and has a layer thickness less than 0.05 µm. Preferably, the transparent front electrode layer 332 is made from aluminum-doped zinc oxide (ZnO:Al), and has a layer thickness ranging from 0.5 µm -1.5 µm.

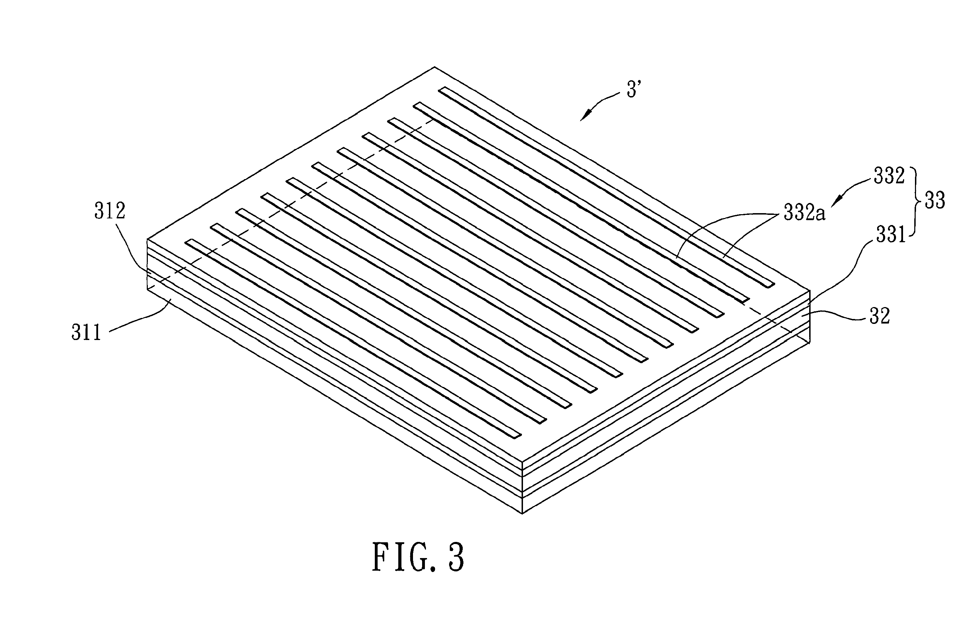

Fig. 3 illustrates a solar cell 3' modified from the solar cell 3 of the first preferred embodiment. The solar cell 3' differs from the solar cell 3 of the first preferred embodiment in that the transparent front electrode layer 332 has a plurality of conductive strips 332a that are spaced apart from one another and that are made from a metallic material. Each of the conductive strips 332a of each of the solar cells 3' extends from the first end portion 301 to the second end portion 302 of the respective one of the solar cells 3' . Alternatively, if the conductive strips 332a have a width sufficiently narrow to not adversely affect transmission of incident light into the solar cell assembly, the conductive strips 332a may be nontransparent.

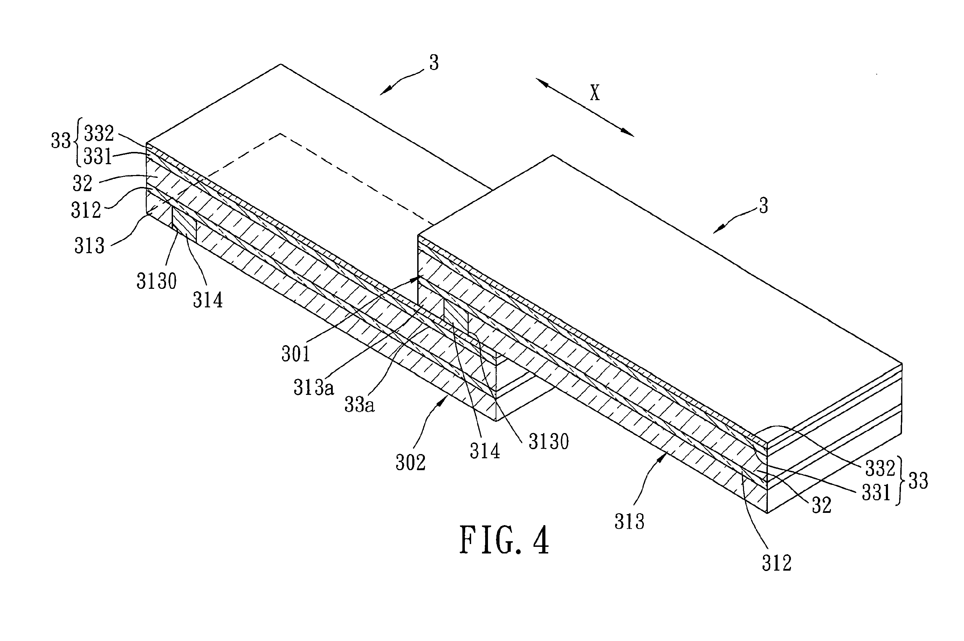

Fig. 4 illustrates the second preferred embodiment of the solar cell assembly according to thepresentinvention.Thesecond preferredembodiment differs from the previous preferred embodiment in that each of the solar cells 3 includes a non-conductive substrate 313 formed with a through-hole 3130, a back electrode layer 312 formed on the non-conductive substrate 313, a conductive connecting block 314 filling the through-hole 3130 and connected to the back electrode layer 312, a top electrode layer structure 33 disposed at one side of the back electrode layer 312 opposite to the non-conductive substrate 313, and a semiconductor photovoltaic layer 32 disposed between the back electrode layer 312 and the top electrode layer structure 33. The non-conductive substrate 313 of each of the solar cells 3 has an end portion 313a corresponding to the first end portion 301 of the respective one of the solar cells 3. The through-hole 3130 is formed in the end portion 313a of the non-conductive substrate 313. The top electrode layer structure 33 of each of the solar cells 3 has an end portion 33a corresponding to the second end portion 302 of the respective one of the solar cells 3. The end portion 313a of the non-conductive substrate 313 of each subsequent one of the solar cells 3 in the series connection together with the conductive connecting block 314 is bonded to the end portion 33a of the top electrode layer structure 33 of the preceding one of the solar cells 3 in the series connection.

Preferably, the non-conductive substrate 313 is made from glass or a polymeric material, such as polyimide or polyester.

Preferably, the conductive connecting block 314 is made from a metal selected from Au, Ag, Cu, and W.

By partially stacking the solar cells 3 one above the other to electrically connect in series the solar cells 3 of the solar cell assembly of this invention, the aforesaid drawbacks associated with the prior art can be eliminated.

## Claims

1. A solar cell assembly **characterized by**:
a plurality of solar cells (3) that are electrically connected to one another to form a series connection and that are aligned along an alignment direction (X), each of said solar cells (3) having opposite first and second end portions (301, 302) that are opposite to each other in said alignment direction (X), said first end portion (301) of a subsequent one of said solar cells (3) in the series connection being stacked on and being electrically connected to said second end portion (302) of a preceding one of said solar cells (3) in the series connection.

2. The solar cell assembly of claim 1, **characterized in that** each of said solar cells (3) includes a metallic substrate (311), a back electrode layer (312) formed on said metallic substrate (311), a top electrode layer structure (33) disposed at one side of said back electrode layer (312) opposite to said metallic substrate (311), and a semiconductor photovoltaic layer (32) disposed between said back electrode layer (312) and said top electrode layer structure (33), said metallic substrate (311) of each of said solar cells (3) having an end portion (311a) corresponding to said first end portion (301) of the respective one of said solar cells (3), said top electrode layer structure (33) of each of said solar cells (3) having an end portion (33a) corresponding to said second end portion (302) of the respective one of said solar cells (3), said end portion (311a) of said metallic substrate (311) of each subsequent one of said solar cells (3) in the series connection being bonded to said end portion (33a) of said top electrode layer structure (33) of the preceding one of said solar cells (3) in the series connection.

3. The solar cell assembly of claim 2, **characterized in that** said top electrode layer structure (33) includes a transparent current diffusion layer (331) formed on said semiconductor photovoltaic layer (32), and a transparent front electrode layer (332) formed on said transparent current diffusion layer (331).

4. The solar cell assembly of claim 2, **characterized in that** said top electrode layer structure (33) includes a transparent current diffusion layer (331) formed on said semiconductor photovoltaic layer, (32) and a front electrode layer (332) formed on said transparent current diffusion layer (331) and having a plurality of conductive strips (332a) that are spaced apart from one another and that are made from a metallic material.

5. The solar cell assembly of claim 2, **characterized in that** said metallic substrate (311) is flexible.

6. The solar cell assembly of claim 2, **characterized in that** said metallic substrate (311) is made from a metallic material selected from Fe, Cr, Ni, and combinations thereof.

7. The solar cell assembly of claim 2, **characterized in that** said metallic substrate (311) is made from stainless steel having a composition comprising 60-77wt% of Fe, 15-32wt% of Cr, and 8-25wt% of Ni.

8. The solar cell assembly of claim 2, **characterized in that** said semiconductor photovoltaic layer (32) is made from a semiconductor material selected from Si, CdTe, CuInSe, and CuInGaSe.

9. The solar cell assembly of claim 1, **characterized in that** each of said solar cells (3) includes a non-conductive substrate (313) formed with a through-hole (3130), a back electrode layer (312) formed on said non-conductive substrate (313), a conductive connecting block (314) filling said through-hole (3130) and connected to said back electrode layer (312), a front electrode layer structure (33) disposed at one side of said back electrode layer (312) opposite to said non-conductive substrate (313), and a semiconductor photovoltaic layer (32) disposed between said back electrode layer (312) and said top electrode layer structure (33), said non-conductive substrate (313) of each of said solar cells (3) having an end portion (313a) corresponding to said first end portion (301) of the respective one of said solar cells (3), said through-hole (3130) being formed in said end portion (313a) of said non-conductive substrate (313), said top electrode layer structure (33) of each of said solar cells (3) having an end portion (33a) corresponding to said second end portion (302) of the respective one of said solar cells (3), said end portion (313a) of said non-conductive substrate (313) of each subsequent one of said solar cells (3) in the series connection together with said conductive connecting block (314) being bonded to said end portion (33a) of said top electrode layer structure (33) of the preceding one of said solar cells (3) in the series connection.

10. The solar cell assembly of claim 9, **characterized in that** said non-conductive substrate (313) is flexible.

11. The solar cell assembly of claim 9, **characterized in that** said semiconductor photovoltaic layer (32) is made from a semiconductor material selected from Si, CdTe, CuInSe, and CuInGaSe.

12. The solar cell assembly of claim 9, **characterized in that** said conductive connecting block (314) is made from a metal selected from the group consisting of Au, Ag, Cu, W and alloys thereof.

13. The solar cell assembly of claim 9, **characterized in that** said top electrode layer structure (33) includes a transparent current diffusion layer (331) formed on said semiconductor photovoltaic layer (32), and a transparent front electrode layer (332) formed on said transparent current diffusion layer (331).
